# FASCICULE DE BREVET EUROPEEN

(11) **EP 1 902 463 B1**
(45) Date de publication et mention de la délivrance du brevet: **14.09.2011**
(21) Numéro de dépôt: 06777736.7
(22) Date de dépôt: 12.07.2006
(51) Int. Cl.: H01L 21/762

(54) **PROCEDE DE DIMINUTION DE LA RUGOSITE D'UNE COUCHE EPAISSE D'ISOLANT**
VERFAHREN ZUR VERRINGERUNG DER RAUHIGKEIT EINER DICKEN ISOLATIONSSCHICHT
METHOD FOR REDUCING ROUGHNESS OF A THICK INSULATING LAYER

(30) Priorité: 13.07.2005 FR 0507573
(43) Date de publication de la demande: 26.03.2008
(73) Titulaire: S.O.I.Tec Silicon on Insulator Technologies, 38190 Bernin (FR)
(72) Inventeur: DAVAL, Nicolas, F-38000 Grenoble (FR); KERDILES, Sébastien, F-38330 Saint-Ismier (FR); AULNETTE, Cécile, F-38000 Grenoble (FR)
(74) Mandataire: Bomer, Françoise Marie
(86) Numéro de dépôt international: PCT/EP2006/064169
(87) Numéro de publication internationale: WO 2007/006803

(56) Documents cités:
- FR-A- 2 857 982
- US-A1- 2004 124 416
- US-A1- 2005 079 712
- US-B1- 6 271 101
- MORICEAU H ET AL: "INTEREST OF A SHORT PLASMA TREATMENT TO ACHIEVE SI-SIO2-SI BONDED STRUCTURES" ELECTROCHEMICAL SOCIETY PROCEEDINGS, ELECTROCHEMICAL SOCIETY, PENNINGTON, NJ, US, vol. 2003-19, 2003, pages 110-117, XP009048675 ISSN: 0161-6374 cité dans la demande
- BECKER F S ET AL: "LOW-PRESSURE DEPOSITION OF HIGH-QUALITY SIO2 FILMS BY PYROLYSIS OF TETRAETHYLORTHOSILICATE" JOURNAL OF VACUUM SCIENCE AND TECHNOLOGY: PART B, AVS / AIP, MELVILLE, NEW YORK, NY, US, vol. 5, no. 6 INDEX, 1 novembre 1987 (1987-11-01), pages 1555-1563, XP000008339 ISSN: 1071-1023
- GHYSELEN B ET AL: "Engineering strained silicon on insulator wafers with the Smart Cut<TM> technology" SOLID STATE ELECTRONICS, ELSEVIER SCIENCE PUBLISHERS, BARKING, GB, vol. 48, no. 8, août 2004 (2004-08), pages 1285-1296, XP004505229 ISSN: 0038-1101

## Description

Dans la description qui suit les unités valent : 1cm=10⁻²m; 1µm=10⁻⁶m; 1nm=10⁻⁹m, et 1Å=10⁻¹⁰m.

La présente invention concerne un procédé de fabrication de substrats destinés à être utilisé dans les domaines de l'électronique, l'optoélectronique ou l'optique, ce procédé étant tel que décrit dans la revendication 1. En particulier, ce procédé inclut une étape de lissage d'une couche épaisse d'isolant, c'est-à-dire de diminution de sa rugosité.

L'invention concerne également un procédé de fabrication qui inclut le procédé de lissage précité et des étapes de collage et de transfert de couches.

L'invention trouve une application particulière dans la réalisation de substrats composites de type "SOI" et "sSOI".

Pour mémoire, les substrats connus sous l'acronyme "SOI" (d'après la terminologie anglaise "*Silicium On Insulator*") correspondent à des substrats dans lesquels une couche d'isolant, plus précisément de dioxyde de silicium (SiO₂), est intercalée entre une couche de silicium support et une couche de silicium superficielle. Dans les substrats "sSOI", la couche superficielle de silicium est contrainte ("*strained Silicon On Insulator*").

Le procédé d'obtention de ce type de substrat comprend une étape de collage d'un substrat dit "support" ou "receveur" sur la couche d'isolant et une étape de transfert de couche.

Le "collage" est ici compris comme un collage par adhésion moléculaire, au cours duquel deux surfaces parfaitement planes adhèrent l'une à l'autre sans application de colle, ceci étant possible à température ambiante.

La qualité du collage obtenu est caractérisée notamment par l'énergie de collage, qui se définie comme la force de liaison existant entre les deux couches collées ensemble.

Cette qualité peut être améliorée en faisant subir aux surfaces à coller, un traitement approprié.

Les isolants utilisés dans les substrats composites précités sont notamment : les oxydes, les nitrures ou les oxynitrures.

Afin d'obtenir ces différents isolants, on connaît déjà, dans l'état de la technique, une technique de dépôt d'une couche de dioxyde de silicium, connue de l'homme du métier sous l'acronyme "LPCVD TEOS", d'après la terminologie anglaise de "*Low Pressure Chemical Vapor Deposition*" et "*Tétraéthylorthosilicate*".

Cette technique consiste à déposer un film de dioxyde de silicium, en utilisant comme matériau source du tétraéthylorthosilicate, et une technique de dépôt en phase vapeur sous faible pression, connue de l'homme du métier sous l'appellation anglaise de LPCVD.

Ce procédé présente de nombreux avantages en ce qui concerne l'uniformité et la densité de la couche d'oxyde obtenue, et permet surtout de ne pas consommer la couche de substrat sur laquelle l'oxyde de silicium ainsi formé repose, ce qui n'est pas le cas lors de la formation d'oxyde par un procédé d'oxydation thermique.

Cependant, la rugosité des couches de dioxyde de silicium déposées par la technique "LPCVD TEOS" est beaucoup plus élevée que celle de couches que l'on oxyde thermiquement. A titre indicatif, la rugosité de surface d'un oxyde TEOS de 150 nm d'épaisseur est supérieure à 5 Å RMS sur une largeur de balayage (« *scan* » en anglais) de 1 µm par 1 µm, alors que celle d'un oxyde thermique est voisine d'environ 1,50 Å RMS sur la même largeur de balayage.

On connaît également d'autres techniques de dépôt, telles que par exemple le dépôt par LPCVD utilisant le silane (SiH₄) comme précurseur, le dépôt chimique en phase vapeur assisté par plasma (connu sous l'anonyme PECVD pour "*Plasma Enhanced Chemical Vapor Deposition*"). On pourra se référer à ce sujet à l'article de Wolf et Tauber «Chemical Vapor deposition of amorphous and polycrystalline flms», Silicon processing for the VLSI ERA, vol 1, pp 189-207, Process Technology.

Toutefois, ces techniques de dépôt conduisent à l'obtention de couches d'isolant dont la rugosité est très élevée.

De plus, la rugosité croît avec l'épaisseur de la couche déposée.

De ce fait, la réalisation d'une couche d'isolant (par exemple d'oxyde) épaisse, c'est-à-dire supérieure à 20 nm - ce qui est fréquemment le cas lors de la fabrication de produits de type SOI - conduit généralement à un niveau de rugosité, incompatible avec les contraintes imposées par un collage par adhésion moléculaire de très bonne qualité. En effet, dans ce cas, il est préférable que la rugosité soit inférieure à 5 Å RMS pour permettre un collage, voire même inférieure à 2 Å RMS, sur des largeurs de balayage (« scan » en anglais) de 1 µm par 1 µm, dans le cadre d'une application de transfert de couche, connue sous la dénomination commerciale « Smart Cut ®».

Le document US-B1-6 271 101 décrit un procédé de fabrication d'un substrat, ce procédé comprenant les étapes suivantes, réalisées dans cet ordre: le dépôt, sur un premier substrat dit «donneur », d'une couche d'isolant; le traitement de lissage de la surface libre de cette couche d'isolant, en utilisant un polissage CMP ou une gravure sèche; et la formation d'une zone de fragilisation par implantation d'hydrogène, à l'intérieur dudit substrat donneur, pour y délimiter une couche dite "active" et un reste.

On connaît déjà d'après l'état de la technique, la possibilité de soumettre un substrat à un traitement par plasma.

Le « traitement par plasma » d'une surface à coller se définit comme l'exposition de cette surface à un plasma gazeux -ceci pouvant se faire notamment sous vide ou à pression atmosphérique- préalablement à la mise en contact des surfaces à coller.

Ce traitement est réalisé en contrôlant divers paramètres d'exposition, tels que la nature et le débit ou la pression du gaz alimentant l'enceinte à l'intérieur de laquelle est réalisée l'opération, ainsi que la densité de puissance.

Il a pour effet de modifier la structure de la couche superficielle du substrat ainsi traité.

On distingue deux types de traitement, le premier, dénommé ci-après « activation plasma », réputé favoriser l'énergie de collage entre deux couches et le second dénommé ci-après « plasma lissant », qui vise à diminuer la rugosité de surface de la couche ainsi traitée.

Les paramètres de mise en oeuvre du plasma, et notamment l'énergie, peuvent être différents dans les deux cas.

On connaît ainsi d'après l'article de D.M. HANSEN et al., "Chemical role of oxygen plasma in water bonding using borosilicate glasses", Applied Physics Letters, Volume 79, numéro 21, 19 novembre 2001, un procédé d'activation plasma d'une couche mince de borosilicates, déposée par LPCVD.

Les verres de type borosilicate sont des alliages de trioxyde de bore (B₂O₃) et de dioxyde de silicium (SiO₂).

L'expérience reportée dans cet article concerne le traitement d'une couche de borosilicates d'environ 30 angströms (3 nm), par un plasma oxygène, en mode RIE ("Reactive Ion Etching"), pendant cinq minutes à 0,6 W/cm², avec une pression à l'intérieur de l'enceinte de 30 mTorr (1 m Torr = 1,33.10⁻¹ Pa).

Les résultats obtenus révèlent une amélioration du collage et montrent que la rugosité de la surface traitée n'est pas affectée par ce traitement d'activation plasma.

D. PASQUARIELLO et al., dans l'article intitulé "Surface engergy as a function of self-bias voltage in oxygen plasma wafer bonding", Sensors and Actuators 82 (2000) 239-244, a étudié l'influence de l'énergie cinétique des ions d'un plasma oxygène, sur l'énergie de collage de plaques de silicium ainsi traitées.

Les essais ont montré qu'une plaque de silicium présentant une rugosité initiale de 0,9 Å RMS pouvait atteindre une rugosité voisine de 0,60 Å RMS, pour une largeur de balayage de 1 µm x 1 µm.

L'auteur conclut en outre que l'énergie cinétique des ions plasma n'a pas la moindre influence sur la qualité du lissage des substrats ainsi traités.

Par ailleurs, l'article de MORICEAU et al. « Interest of a short plasma treatment to achieve high quality Si-SiO2-Si bonded structures », Abrégé n° 1006, ECS 2003, a montré l'effet lissant d'un plasma sur des oxydes thermiques de SiO₂. Toutefois cet article ne concerne que des oxydes dont la rugosité initiale est assez faible (2,3 Å RMS pour 0,5 µm x 0,5 µm à 20 µm x 20 µm de balayage). En outre, cet article n'évoque pas la possibilité de former une zone de fragilisation, par une implantation de type Smart Cut® dans le substrat supportant l'oxyde, ni en conséquence les potentiels effets bénéfiques du plasma lissant observés lors d'un report de couche ultérieur.

Enfin, on connaît également d'après le document US-2004/0124416 un procédé de diminution de la rugosité d'une couche de matériau diélectrique qui utilise un traitement plasma.

Toutefois, ce document n'évoque pas la possibilité d'effectuer un traitement d'implantation d'espèces atomiques de type Smart Cut® entre un traitement de plasma lissant et un collage, suivi d'un report de couche. Les effets bénéfiques sur la diminution du nombre de défauts observés sur la couche reportée ne sont absolument pas envisagés.

L'invention a au contraire pour but de diminuer sensiblement la rugosité d'une couche épaisse d'isolant, que l'on ne souhaite pas ou que l'on ne peut pas former par oxydation sur son substrat de départ et dont la rugosité initiale est importante.

Par couche "rugueuse", on entend ici une couche dont la rugosité est supérieure ou égale à 3 angströms RMS, de préférence comprise entre 3 et 20 angströms RMS environ, pour un balayage de 2 µm x 2 µm.

L'invention a également pour but de fournir un procédé de fabrication d'un substrat intermédiaire, qui comprend une zone de fragilisation obtenue par implantation d'espèces atomiques et qui est recouvert d'une couche d'isolant épaisse dont la rugosité est importante, ce substrat intermédiaire pouvant être utilisé ultérieurement dans un procédé de collage et de transfert de couche, afin d'obtenir un substrat dont la couche reportée présente peu ou pas de défauts.

A cet effet, l'invention concerne un procédé de fabrication d'un substrat apte à être utilisé dans les domaines de l'électronique, l'optoélectronique et l'optique, caractérisé en ce qu'il comprend au moins les étapes suivantes, réalisées dans cet ordre :
a) le dépôt, sur un premier substrat dit « donneur », d'une couche d'isolant dont l'épaisseur est supérieure ou égale à 20 nm et dont la rugosité est supérieure ou égale à 3 angströms RMS, pour une largeur de balayage de 2 µm x 2 µm,
b) le traitement de lissage de la surface libre de cette couche d'isolant, en utilisant un plasma gazeux, formé dans une enceinte à l'intérieur de laquelle règne une pression de gaz supérieure à 0,25 Pa, ce plasma étant créé à l'aide d'un générateur de radiofréquences, qui fonctionne avec une puissance telle, qu'il permet d'appliquer à ladite couche d'isolant, une densité de puissance supérieure à 0,6 W/cm², la durée de ce traitement de lissage étant d'au moins 10 secondes,
c) la formation d'une zone de fragilisation par implantation d'espèces atomiques, à l'intérieur dudit substrat donneur, pour y délimiter une couche, dite "active" et un reste.
   Selon d'autres caractéristiques avantageuses, prises seules ou en combinaison :
   - le procédé comprend les étapes suivantes, réalisées après l'étape c) :
      d) le collage par adhésion moléculaire d'un second substrat, dit « receveur », sur ladite surface libre de la couche d'isolant,
      e) le retrait dudit reste.
   - le procédé comprend une étape de recuit de densification de l'isolant déposé à l'étape a), ce recuit étant effectué à une température comprise entre 700 et 1000°C, pendant une durée de plusieurs minutes à plusieurs heures, dans une atmosphère oxydante ou neutre.
   - ledit traitement de recuit de densification est effectué après l'étape b) de lissage par plasma et avant l'étape c) d'implantation d'espèces atomiques.
   - le traitement de lissage par plasma est effectué avec une densité de puissance comprise entre 0,6 et 10 W/cm², une pression du gaz à l'intérieur de l'enceinte comprise entre 0,25 et 30 Pa et une durée du traitement comprise entre 10 et 200 secondes.
   - la pression du gaz à l'intérieur de l'enceinte est comprise entre 3 et 13 Pa, de préférence elle est voisine de 7 Pa.
   - la durée de l'étape b) de traitement de lissage par plasma est comprise entre 30 et 120 secondes environ.
   - le gaz utilisé pour la formation du plasma de lissage est choisi parmi l'oxygène (O₂), l'argon (Ar), l'azote (N₂) ou un mélange de ces gaz.
   - le gaz utilisé pour la formation du plasma de lissage (SP) est choisi de façon que la nature des atomes le constituant soit la même qu'au moins l'un des atomes constituant ladite couche d'isolant (2) à traiter.
   - entre les étapes c) et d), on procède à un traitement d'activation plasma de ladite couche d'isolant, en utilisant un plasma gazeux, formé dans une enceinte à l'intérieur de laquelle règne une pression de gaz d'environ 7 Pa, ce plasma étant créé à l'aide d'un générateur de radiofréquences RF, qui fonctionne avec une puissance telle, qu'il permet d'appliquer à ladite couche d'isolant, une densité de puissance supérieure à 0,2 W/cm², la durée de ce traitement d'activation plasma étant d'au moins 5 secondes.
   - le traitement d'activation plasma est effectué avec une densité de puissance comprise entre 0,2 et 3 W/cm², et une durée de traitement comprise entre 5 et 60 secondes.
   - l'épaisseur de la couche d'isolant est supérieure ou égale à 200 nm.
   - l'isolant est obtenu par une technique de dépôt chimique en phase vapeur sous faible pression LPCVD.
   - l'isolant est un oxyde.
   - l'oxyde est un dioxyde de silicium, obtenu par une technique de dépôt chimique en phase vapeur sous faible pression, à partir de tétraéthylorthosilicate (LPCVD TEOS).
   - le dioxyde de silicium (SiO₂) est déposé à une pression comprise entre 40 et 200 Pa.
   - l'isolant est un nitrure ou un oxynitrure.
   - ladite couche active comprend du silicium.
   - ladite couche active comprend du silicium contraint.

D'autres caractéristiques et avantages de l'invention apparaîtront de la description qui va maintenant en être faite, en référence aux dessins annexés, qui en représentent un mode de réalisation possible.

Sur ces dessins :
- les figures 1A à 1F sont des schémas illustrant les différentes étapes successives d'un premier mode de réalisation du procédé conforme à l'invention ;
- les figures 2A à 2H sont des schémas illustrant les différentes étapes d'un second mode de réalisation du procédé conforme à l'invention ;
- la figure 3 est un graphique représentant la rugosité **R** du bord d'une couche de dioxyde de silicium, après le traitement plasma conforme à l'invention, en fonction de la puissance appliquée, et ce pour différentes durées d'application ;
- la figure 4 est un graphique représentant la rugosité **R** du bord d'une couche de dioxyde de silicium, après le traitement plasma conforme à l'invention, en fonction du temps, et pour différentes gammes de puissances du plasma ;
- les figures 5 et 6 sont des graphiques, similaires respectivement à ceux des figures 3 et 4, mais pour des mesures effectuées au centre de la couche de dioxyde de silicium ;
- la figure 7 est un graphique représentant le nombre **N** de défauts de différents types, avant et après le traitement de plasma lissant conforme à l'invention ;
- les figures 8 et 9 sont des graphiques représentant la durée **t** d'une onde de collage, exprimée en secondes, en fonction du nombre d'ondes de collage NO présentant cette durée de collage, respectivement des couches d'isolant (SiO₂) n'ayant pas subi de traitement de plasma lissant ou en ayant subi un, et
- la figure 10 est un graphique représentant le nombre de défauts de différents types, observés sur des substrats obtenus soit à l'issue du procédé conforme à l'invention, soit à l'issue d'un procédé comparatif.

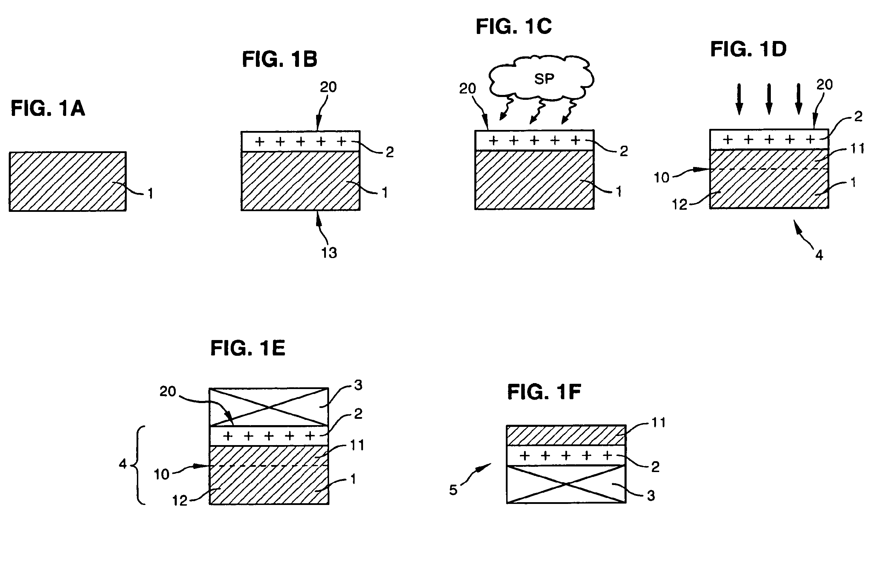

En se reportant à la figure 1, on peut voir les différentes étapes d'un premier mode de réalisation du procédé conforme à l'invention.

Les figures 1A et 1B représentent respectivement un substrat donneur 1, avant et après qu'il ne soit recouvert par le dépôt d'une couche d'isolant 2 épaisse. La face du substrat donneur 1 opposée à celle sur laquelle a été déposée la couche d'isolant 2 est dite « face arrière» et porte la référence 13.

Le substrat donneur 1 peut être monocouche ou multicouches. Il est généralement réalisé dans un matériau semi-conducteur, par exemple du silicium.

Le substrat donneur 1 peut également comprendre un matériau contraint, tel que du silicium contraint. Dans ce dernier cas, le substrat est généralement multicouches, et la couche de matériau contraint est alors obtenue par épitaxie, sur une couche de matériau support.

L'isolant 2 peut être, par exemple, une couche de nitrure, d'oxynitrure ou de préférence une couche d'oxyde.

L'épaisseur de l'isolant est supérieure ou égale à 20 nm, de préférence supérieure ou égale à 200 nm. Sa rugosité est supérieure ou égale à 3 angströms RMS, pour une largeur de balayage de 2 µm x 2 µm.

Conformément à l'invention, on réalise ensuite une étape de plasma lissant, dont les modalités seront décrites ultérieurement. Celle-ci est représentée sur la figure 1C. La référence SP correspond à la terminologie anglaise de « *smoothing plasma* » qui désigne un plasma lissant.

Enfin, on réalise une étape d'implantation d'espèces atomiques, comme représenté sur la figure 1D.

Cette implantation permet de former à l'intérieur du substrat donneur 1 une zone de fragilisation 10, qui délimite une couche mince supérieure 11, du reste 12 du substrat.

L'expression "couche mince" désigne une couche de quelques dizaines ou centaines de nanomètres d'épaisseur.

Pour une description générale de ces méthodes d'implantation, on pourra se reporter à l'ouvrage "Silicon on Insulator Technologies" ; Materials to VLSI, 2^{ème} Edition (Jean-Pierre COLINGE) ou à la littérature concernant le procédé de type "Smart Cut" (marque déposée).

Conformément à l'invention, les trois étapes qui viennent d'être décrites, à savoir le dépôt de l'isolant, le traitement de plasma lissant **SP** et l'implantation d'espèces atomiques, représentées respectivement sur les figures 1B, 1C et 1D, sont effectuées impérativement dans cet ordre. Toutefois, comme cela sera décrit ultérieurement, des étapes complémentaires peuvent être intercalées entre ces trois étapes.

A l'issue de l'étape d'implantation, on obtient un substrat 4, dit "substrat intermédiaire", apte à être utilisé dans des procédés de collage et de report de couches, mis en oeuvre dans les domaines de l'électronique, l'opto-électronique et l'optique.

Ces étapes sont illustrées sur les figures 1E et 1F.

Comme illustré sur la figure 1E, on peut poursuivre le procédé en collant sur la surface libre 20 de la couche d'isolant 2 du substrat intermédiaire 4, un substrat receveur 3.

Le substrat receveur 3 est en matériau semi-conducteur.

Puis, on procède au détachement du reste 12 du substrat donneur 1, le long de la zone de fragilisation 10.

On obtient ainsi le substrat composite final 5 représenté sur la figure 1F, dans lequel la couche d'isolant 2 est intercalée à l'intérieur de deux couches de matériau semi-conducteur 3, 11.

Bien que cela n'ait pas été représenté sur les figures, le substrat receveur 3 pourrait être multicouches.

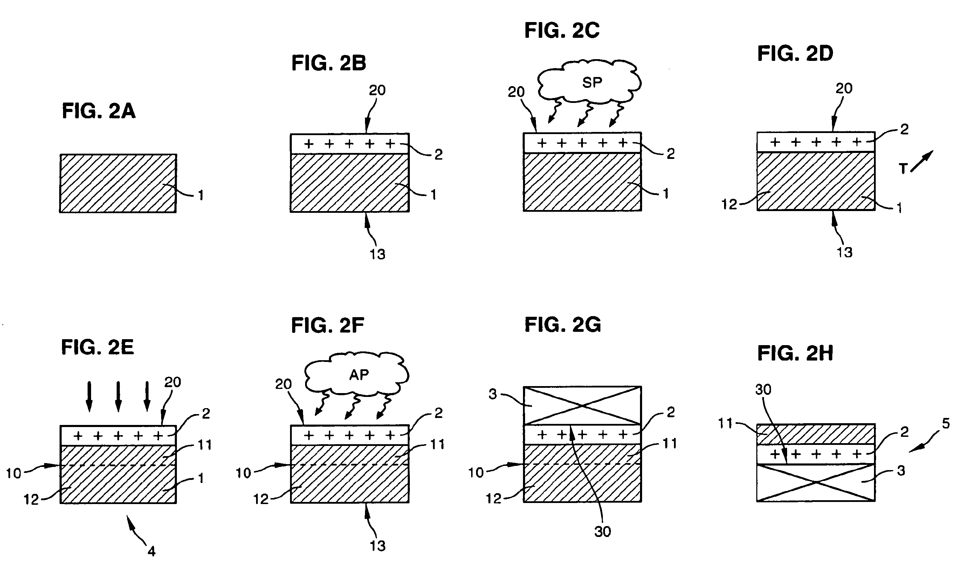

La figure 2 illustre une variante de réalisation du procédé précédent. Les éléments identiques portent les mêmes références numériques.

Cette variante de réalisation se distingue de la précédente, en ce qu'elle comprend deux étapes supplémentaires, l'une de traitement thermique de densification représentée sur la figure 2D et l'autre de traitement d'activation plasma illustrée sur la figure 2F.

Les autres étapes du procédé sont identiques à ce qui a été décrit précédemment pour la figure 1 et portent les mêmes références numériques.

L'étape de recuit de densification de l'isolant 2 qui a été déposé sur le substrat 1 est optionnelle mais conseillée.

Cette étape de recuit de densification est effectuée avant l'étape d'implantation d'espèces atomiques.

De plus, elle est de préférence effectuée après l'étape de lissage par plasma (SP). Toutefois, et bien que cela ne soit pas représenté sur les figures, elle pourrait également être effectuée après le dépôt de l'isolant, mais avant l'étape de lissage par plasma.

Le traitement d'activation par plasma **AP** est optionnel. Il peut être effectué sur la face ayant subi le traitement de lissage plasma (SP), c'est-à-dire la face 20, comme représenté sur la figure 2F. Il peut également être effectué sur la face 30 du substrat 3 destinée à être collée sur la face 20. Il peut également être effectué sur les deux faces 20 et 30.

La référence **AP** correspond à la terminologie anglaise de « *activation plasma* » qui désigne un traitement d'activation plasma.

Enfin, bien que non représenté sur les figures, un traitement de nettoyage pré et/ou post-activation plasma (AP) peut être effectué, selon des modalités décrites ultérieurement, après l'implantation d'espères atomiques et avant l'activation plasma ou après l'activation plasma et avant le collage du substrat receveur 3.

Les modalités de mises en oeuvre des différentes étapes précitées vont maintenant être décrites plus en détails.

### Modalités de dépôt de la couche d'isolant :

La couche d'isolant 2 est formée sur le substrat donneur 1, par dépôt, notamment par dépôt chimique en phase vapeur, et de préférence à faible pression, technique connue sous l'acronyme anglais de "LPCVD".

Une autre technique peut également être utilisée, telle que le dépôt chimique en phase vapeur assisté par plasma, connu sous l'acronyme PECVD. On pourra se reporter à ce sujet à l'article précité de Wolff et Tauber.

Cette étape du procédé peut être mise en oeuvre avec un réacteur pour le dépôt chimique en phase vapeur. Celui-ci comprend une enceinte de traitement, à l'intérieur de laquelle est disposé le substrat. Les différents réactifs chimiques, sous forme de flux gazeux, sont ensuite introduits à l'intérieur de cette enceinte, à une température élevée et sous faible pression, de façon à former la couche d'isolant 2, après réaction chimique entre les différents constituants gazeux.

L'une des applications visée dans l'invention consiste en la fabrication d'un substrat de type SOI.

Dans ce cas, une variante de réalisation préférentielle du dioxyde de silicium (SiO₂) consiste à effectuer un dépôt connu sous l'appellation précitée TEOS LPCVD, en utilisant du tétraéthylorthosilicate (TEOS), selon la réaction chimique suivante :

Si(OC₂H₅)₄(gaz) → SiO₂(solide) + 2C₂H₄(gazeux)+ 2CH₃CH₂0H(gazeux)

La pression à l'intérieur de l'enceinte du réacteur LPCVD est comprise entre 300 mTorr et 1,5 Torr (soit entre 40 et 200 Pa), de préférence voisine de 750 mTorr, (soit voisine de 100 Pa).

L'épaisseur du dioxyde de silicium est ajustée pour être d'au moins 20 nm, voire supérieure ou égale à 200 nm et jusqu'à quelques micromètres.

### Recuit de densification:

Il est effectué par un traitement thermique à une température comprise entre 700 et 1000°C, pendant une durée de plusieurs minutes à plusieurs heures, dans une atmosphère oxydante ou neutre.

Il a pour objet de rendre l'isolant plus dense et d'éliminer les espèces carbonées.

### Configuration de l'installation permettant la réalisation du traitement de lissage ou du traitement d'activation plasma :

Le traitement est mis en oeuvre avec une installation comprenant une enceinte à plasma, à l'intérieur de laquelle la pression et la composition de l'atmosphère gazeuse sont contrôlées. Il existe plusieurs types de telles installations.

L'invention peut ainsi être mise en oeuvre avec une installation du type "par gravure ionique réactive", connue sous l'abréviation "RIE". L'installation comprend un générateur RF (radiofréquence) unique, alimentant, via un couplage capacitif, une électrode située à l'intérieur de l'enceinte et qui supporte le substrat 1 recouvert de la couche d'isolant 2 à lisser et/ou à activer.

C'est ce générateur RF unique qui permet de générer le plasma (c'est-à-dire d'exciter ses espèces).

Et la « puissance » dont il est question dans ce texte, et qui est un des paramètres de l'activation, correspond plus précisément à la puissance de ce générateur.

Le contrôle de la puissance de ce générateur permet à la fois d'exciter le plasma, et de contrôler l'énergie cinétique des ions du plasma, qui bombardent la surface de la couche d'isolant 2.

L'enceinte à plasma comporte en outre une deuxième électrode, non reliée au substrat à traiter. Cette deuxième électrode est reliée à la masse.

Selon une autre variante, il est également possible de mettre en oeuvre l'invention, avec une installation similaire à celle qui vient d'être mentionnée, mais dans laquelle la deuxième électrode est reliée à un deuxième générateur RF.

Dans ce cas, c'est le deuxième générateur RF (relié à l'électrode avec laquelle la couche d'isolant à traiter n'est pas en contact) qui génère et entretient le plasma. Ce deuxième générateur est ainsi commandé pour contrôler la densité du plasma. Le contrôle de la puissance du premier générateur permet de réguler uniquement l'énergie cinétique des ions du plasma, qui bombardent la surface de la couche à traiter.

### Paramètres du plasma lissant :

La puissance RF du plasma est une puissance élevée. Elle varie de 200 à 3 000 W, pour des substrats de 200 mm de diamètre, soit une densité de puissance d'au moins 0,6 W/cm² et de préférence comprise entre 0,6 à 10 W/cm². La demanderesse a en effet constaté que plus le traitement plasma est réalisé à forte puissance RF, plus la rugosité de la couche d'isolant 2 traité sera diminuée.

Par ailleurs, la durée de ce traitement plasma est avantageusement d'au moins 10 secondes, de préférence comprise entre 10 et 200 secondes, typiquement entre 30 et 60 secondes. La demanderesse a également constaté que plus la durée du traitement plasma est longue et plus la surface de la couche d'isolant est lissée.

Le gaz utilisé pour former le plasma peut être de l'oxygène, de l'azote ou de l'argon ou une combinaison de ces gaz (Ar+O₂ ; Ar+N₂ ; O₂+N₂ ; Ar+O₂+N₂). Le traitement de lissage peut également être effectué en deux temps, à savoir par exemple 60s sous plasma d'Argon à forte puissance, puis 30s sous plasma O₂ à une puissance plus modérée.

D'une façon préférentielle, le traitement de lissage par plasma est effectué avec des atomes de gaz de même nature qu'au moins l'un de ceux constituant la couche d'isolant traitée. On aura ainsi, par exemple, un traitement de lissage par plasma d'oxygène pour lisser une couche d'oxyde de silicium, un plasma d'azote pour lisser une couche de nitrure de silicium.

Il est en effet préférable de ne pas modifier la stoechiométrie et donc la chimie du matériau traité lors de ce type de traitement plasma.

Les valeurs de pression typiquement utilisées sont supérieures à 2 mTorr, de préférence comprises entre 2 et 200 mTorr, préférentiellement 20 à 100 mTorr, de préférence encore voisines de 50 mTorr, (c'est-à-dire, supérieures à 0,25 Pa, de préférence comprises entre 0,25 Pa et 30 Pa, de préférence entre 3 Pa et 13 Pa, de préférence encore voisines de 7 Pa).

Bien que le traitement de plasma lissant soit mené avec une énergie et une durée particulièrement importantes, qui ne sont pas forcément compatibles avec l'obtention d'un collage fort, il ne faut toutefois pas exclure la situation où la rugosité initiale et le choix de la face à implanter permettrait d'avoir des paramètres de procédé qui fonctionnent à la fois pour le lissage et l'activation, en particulier si le lissage est pratiqué en deux temps comme décrit précédemment.

Le traitement de lissage par plasma peut également être volontairement plus fort en bord de plaque (respectivement au centre), de façon à obtenir une rugosité finale uniforme, lorsque l'on utilise au départ une surface plus rugueuse au bord (respectivement au centre). Les paramètres permettant ce type de correction différentielle (centre/bord) sont tous ceux connus de l'homme du métier pour faire varier l'uniformité du plasma (pression, différentiel de densité de puissance centre/bord), débits différents entre centre et bord, etc.).

### Traitement de nettoyage pré et/ou post activation plasma :

Un nettoyage approfondi de la surface à activer peut être réalisé, par exemple à l'aide d'un traitement dans un bain chimique dénommé "RCA", afin d'éviter toute contamination.

Le traitement "RCA" consiste à traiter les surfaces, successivement avec :
- un premier bain d'une solution connue sous l'acronyme "SC1", (d'après la terminologie anglo-saxonne de "Standard Clean 1 ", qui signifie "solution de nettoyage standard 1 "), et qui comprend un mélange d'hydroxyde d'ammonium (NH₄OH), de peroxyde d'hydrogène (H₂O₂) et d'eau déionisée,
- un second bain d'une solution connue sous l'acronyme "SC2", (d'après la terminologie anglo-saxonne de "Standard Clean 2", qui signifie "solution de nettoyage standard 2"), et qui comprend un mélange d'acide chlorhydrique (HCl), de peroxyde d'hydrogène (H₂O₂) et d'eau déionisée.

### Paramètres de l'activation plasma :

Elle est avantageusement effectuée à plus faible puissance que le plasma lissant, par exemple, avec une densité de puissance RF comprise entre 0.2 et 3 W/cm², de préférence voisine de 0.6 W/cm², pour augmenter encore l'énergie de collage avec le substrat receveur.

De préférence, on utilise une durée de traitement comprise entre 5 et 60 secondes et une pression de gaz à l'intérieur de l'enceinte d'environ 7 Pa (50 mTorr).

Différents essais ont été effectués afin de montrer l'efficacité du procédé conforme à l'invention.

### Essai 1 :

Des essais ont été effectués sur plusieurs substrats, en faisant varier les différents paramètres du traitement de plasma lissant (SP), afin d'étudier la rugosité de la couche d'isolant ainsi traitée, à la fois au centre et sur les bords.

Cette mesure de la rugosité a été effectuée par microscopie à force atomique (connue sous l'acronyme "AFM", d'après la terminologie anglaise "Atomic Force Microscopy").

Les essais ont été effectués sur une couche d'isolant constituée de dioxyde de silicium, obtenue par un dépôt LPCVD TEOS. L'épaisseur de la couche de SᵢO₂ d'isolant était de 145 nm et sa rugosité initiale avant le traitement de plasma lissant, de l'ordre de 4 à 4,5 Å RMS pour une largeur de balayage de 2 µm x 2 µm.

On a utilisé des puissances de plasma de 250, 600 et 1000 W, pendant des durées respectives de 10, 30 et 60 secondes. Les résultats sont reportés dans le tableau ci-dessous, dans le cas d'un plasma à l'oxygène, pour des plaques de 200 mm de diamètre.

**Tableau 1**

| Puissance utilisée | Durée du traitement | Localisation de la mesure | 2 X 2 µm² RMS [Å] |
|---|---|---|---|
| 250 W | 10 s | Centre | 3.64 |
| | | Bord | 3.77 |
| | 30 s | Centre | 3.53 |
| | | Bord | 3.29 |
| | 60 s | Centre | 3.07 |
| | | Bord | 3.04 |
| 600 W | 10 s | Centre | 3.64 |
| | | Bord | 3.66 |
| | 30 s | Centre | 2.62 |
| | | Bord | 2.89 |
| | 60 s | Centre | 2.37 |
| | | Bord | 2.39 |
| 1 000 W | 10 s | Centre | 3.29 |
| | | Bord | 3.63 |
| | 30 s | Centre | 2.43 |
| | | Bord | 2.55 |
| | 60 s | Centre | 2.07 |
| | | Bord | 2.07 |

Les valeurs de rugosité sont exprimées en angströms RMS pour des largeurs de balayage (« *scan* ») de 2 µm par 2 µm.

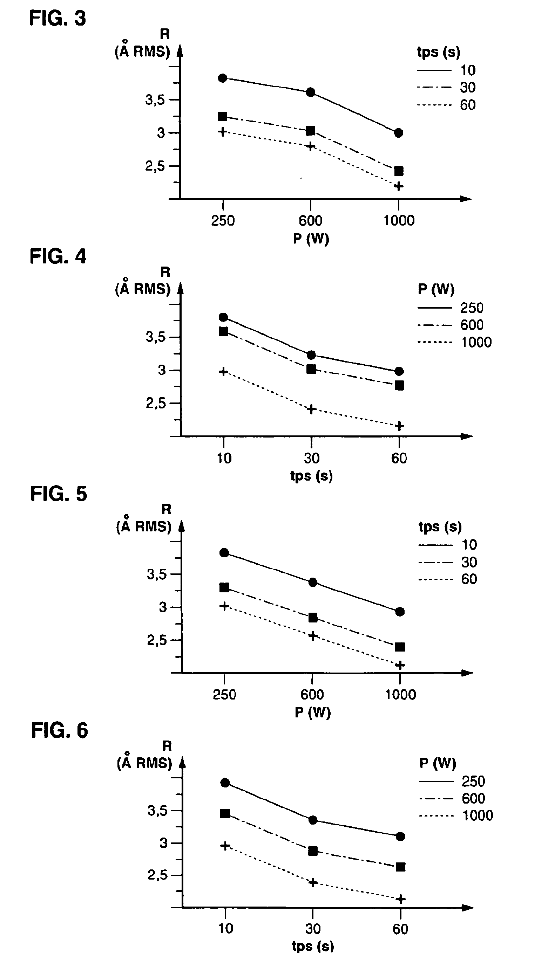

Ces résultats ont par ailleurs été reportés sur les graphiques des figures 3 à 6.

En les observant, on constate ainsi une amélioration de la rugosité initiale, cette amélioration étant renforcée par l'emploi d'un plasma lissant à haute puissance, (de préférence au moins 600 W ou mieux encore 1000 W) et de longue durée.

A l'issue de ce traitement plasma, la demanderesse a également constaté que le dioxyde de silicium conservait une bonne uniformité.

La diminution de la rugosité est réelle, s'effectue à basse température et permet d'éviter une étape ultérieure de polissage mécanico-chimique.

De ce fait, la couche d'isolant ainsi traitée peut être utilisée pour effectuer un collage de très bonne qualité sur un substrat receveur et, ultérieurement, un transfert de couche par un détachement également de bonne qualité, qui évite tous les problèmes d'apparition de cloques, de zone d'exclusion (« couronne »), de picots ou de formation de zones non transférées.

### Essai 2 :

D'autres essais complémentaires ont été réalisés sur des substrats en silicium contraint sur isolant (sSOI) incluant un oxyde TEOS lissé, intercalé entre une couche mince de silicium contraint et une couche support de silicium. Dans ce cas de figure, la puissance de lissage est d'environ 1000 W pendant environ 60 s, pour des plaques de 200 mm de diamètre, soit une densité de puissance de 3 W/cm². La pression de gaz utilisée pendant le lissage était de 50 mTorr (environ 7 Pa).

Les résultats obtenus sont reportés dans le tableau ci-dessous.

**Tableau 2**

| Densification | Nature du traitement | Localisation de la mesure | 2 X 2 µm² RMS [Å] |
|---|---|---|---|
| NON | Témoin | Centre | 4.94 |
| | | Bord | 5.23 |
| | Plasma lissant à 1000 W pendant 60 secondes | Centre | 2.29 |
| | | Bord | 2.33 |
| OUI | Témoin implanté | Centre | 5.37 |
| | | Bord | 6.3 |
| | Plasma lissant à 1000 W pendant 60 secondes, suivi d'une implantation | Centre | 2.36 |
| | | Bord | - |

Par ailleurs, des tests comparatifs ont également été effectués sur les substrats de type sSOI précités, après le report de la couche mince 11 de silicium contraint, certains de ces substrats ayant subi le traitement de plasma lissant précité, au cours de leur fabrication, d'autres substrats ne l'ayant pas subi.

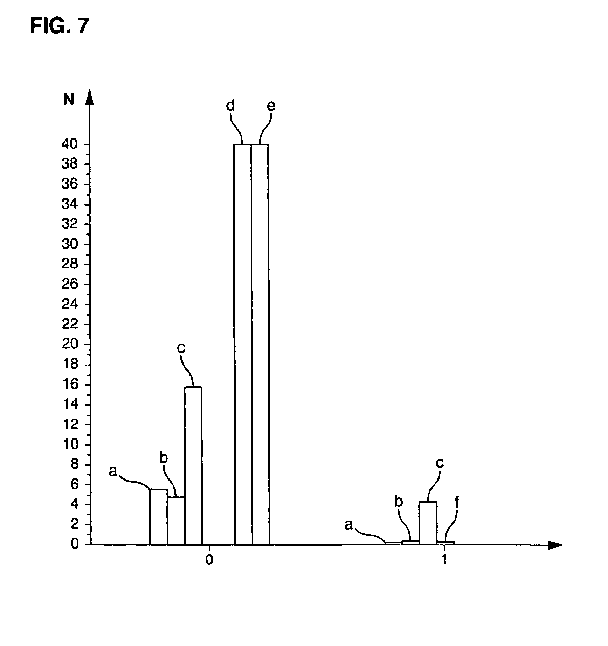

Les résultats obtenus sont reportés sur la figure 7, sur laquelle N représente le nombre de défauts et 0 et 1 indiquent respectivement l'absence de traitement par plasma lissant, ou au contraire sa réalisation.

Les références **a** à **f** ont la signification suivante :
**a :** grande zone non transférée (diamètre supérieur à 1,5 mm)
**b :** petite zone non transférée (diamètre entre 0.5 et 1,5 mm)
**c :** micro zones non transférées (diamètre inférieur à 0,5 mm)
**d :** cloques
**c :** microcloques
**f :** picots (zones non transférées en bord de plaque).

On passe ainsi d'une centaine de défauts par plaque à une dizaine, voire même moins, grâce au plasma lissant conforme à l'invention.

### Essai 3 :

D'autres essais ont été effectué afin d'étudier l'effet du plasma lissant sur le temps de collage.

Les mesures effectuées ont consisté à mesurer le temps de collage, c'est-à-dire la durée d'une onde de collage entre un substrat en silicium, recouvert d'une couche de SiO₂ obtenue par dépôt LPCVD et TEOS, et un substrat receveur également en silicium.

Les essais ont été réalisés avec différents lots de substrats de 200 mm de diamètre, dont les oxydes présentaient des rugosités de surfaces différentes, de 3 à 6 angströms RMS pour une largeur de balayage de 2 µm x 2 µm. Ces oxydes avaient subi un traitement de plasma lissant, en utilisant des puissances comprises entre 1000 W et 1500 W, soit des densités de puissance comprises entre 3,2 W/cm² et 4,7 W/cm² pour des diamètres de 200 mm et pendant des durées allant de 60 à 120 secondes.

La pression du gaz dans l'enceinte était de 50 mTorr (environ 7 Pa).

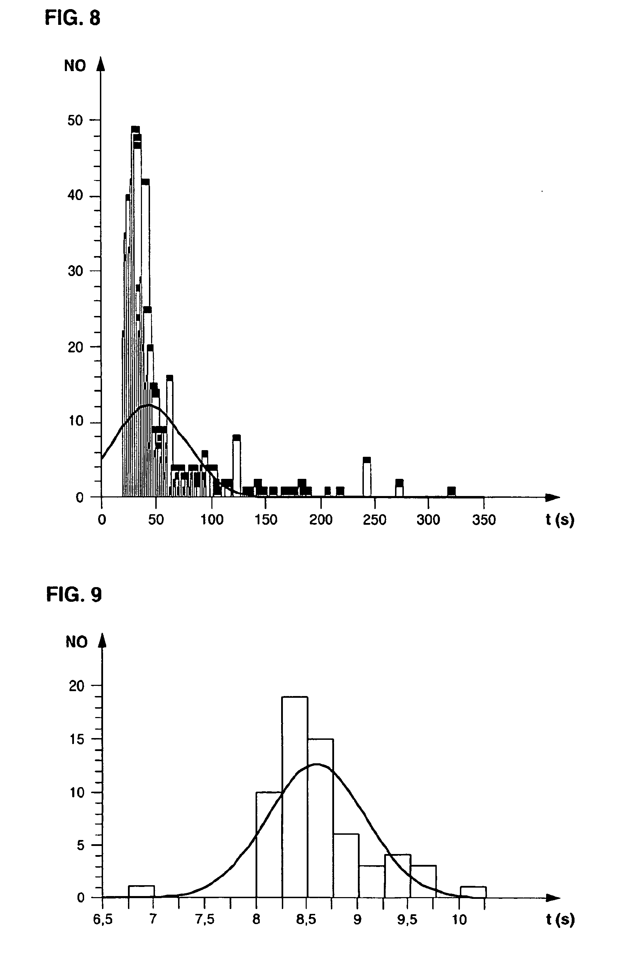

La figure 8 illustre les résultats obtenus pour des oxydes n'ayant pas subi le traitement de plasma lissant. Elle représente la durée t d'une onde de collage, exprimée en secondes, en fonction du nombre d'ondes de collage **NO** présentant cette durée de collage.

La figure 9 illustre les résultats obtenus pour des oxydes ayant subi le traitement de plasma lissant conforme à l'invention.

On observe que lorsque aucun traitement de plasma lissant n'est effectué, la durée de l'onde de collage ou temps de collage est en moyenne de 43,7 secondes avec un écart type de 33 secondes, tandis qu'après un plasma lissant, le temps de collage est réduit à 8,6 secondes avec un écart type de 0,5 seconde.

Le traitement de plasma lissant a donc pour effet de réduire le temps de collage et de ce fait, d'augmenter l'énergie de collage et de rendre ce collage beaucoup plus homogène et reproductible.

### Essai 4 :

Les substrats testés sont des plaques de sSOI de 200 mm de diamètre. Ils ont été fabriqués à partir d'un substrat donneur comprenant une couche de silicium contraint à forte topologie de surface, sur lequel une couche d'oxyde de silicium de l'ordre de 1650 angströms (165 nm) (entre 1600 et 1700 angströms, entre 160 et 170 nm) d'épaisseur a été déposée par dépôt TEOS LPCVD...

La notion de topologie est à distinguer de la notion de rugosité. Cette dernière s'apprécie à l'échelle microscopique. Au contraire, la notion de topologie s'apprécie à l'échelle macroscopique et désigne les différences entre les points les plus haut et les plus bas d'une surface ("*pick to valley*" en anglais), sur une aire d'environ 1cm².

La forte topologie du silicium contraint du donneur a une incidence sur la topologie de la couche d'isolant déposée sur celui-ci.

La rugosité initiale de l'oxyde de silicium était de 4 à 6 angströms RMS, pour un balayage de 2 µm x 2 µm.

Différents traitements exposés ci-après ont été appliqués à différents lots de ces substrats donneurs, puis un substrat receveur en silicium a été appliqué sur la couche d'oxyde de chacun d'entre eux et la couche de silicium contraint a été détachée du substrat donneur pour être reportée sur le substrat receveur et former le substrat final.

| **Essai A** | **Essai B** | **Essai C** | **Essai D** | **Essai E** |
|---|---|---|---|---|
| Lissage standard | Lissage doux | Densification de l'oxyde | Densification de l'oxyde | Densification de l'oxyde |
| Densification de l'oxyde | Densification de l'oxyde | Lissage standard | Implantation d'espèces atomiques | Implantation d'espèces atomiques |
| Implantation d'espèces atomiques | Implantation d'espèces atomiques | Implantation d'espèces atomiques | Lissage doux | Lissage doux |
| Activation plasma (AP) du substrat receveur | Activation plasma (AP) du substrat receveur | Activation plasma (AP) du substrat receveur | Activation plasma (AP) du substrat receveur | Pas d'activation plasma du substrat receveur |

Le lissage standard a été obtenu en utilisant un plasma d'oxygène, formé dans une enceinte à l'intérieur de laquelle régnait une pression de gaz de 50 mT (soit 7 Pa). Ce plasma a été créé à l'aide d'un générateur de radiofréquences RF qui fonctionne avec une densité de puissance de l'ordre de 3 watts par cm² et une durée de traitement de 60 secondes. Le flux d'oxygène était de 75 sccm.

Le lissage doux a été obtenu en utilisant un plasma d'oxygène, formé dans une enceinte à l'intérieur de laquelle régnait une pression de gaz de 150 mT (soit environ 20 Pa). Ce plasma a été créé à l'aide d'un générateur de radiofréquences RF qui fonctionne avec une densité de puissance de l'ordre de 1,5 watts par cm² et une durée de traitement de 60 secondes. Le flux d'oxygène était de 200 sccm.

La densification par recuit thermique de l'oxyde a été obtenue par un traitement thermique à environ 850°C, pendant 2 heures.

L'implantation des espèces atomiques a été effectuée par une implantation d'ions d'environ 30 keV, selon une dose de l'ordre de 6.10¹⁶ H⁺/cm².

L'activation plasma (AP) du substrat receveur a été effectuée sous une pression de 50 mTorr (environ 7 Pa) à une puissance de 250 W, sous un flux d'oxygène de 75 sccm (scare cubic centimeter) pendant environ 10 secondes.

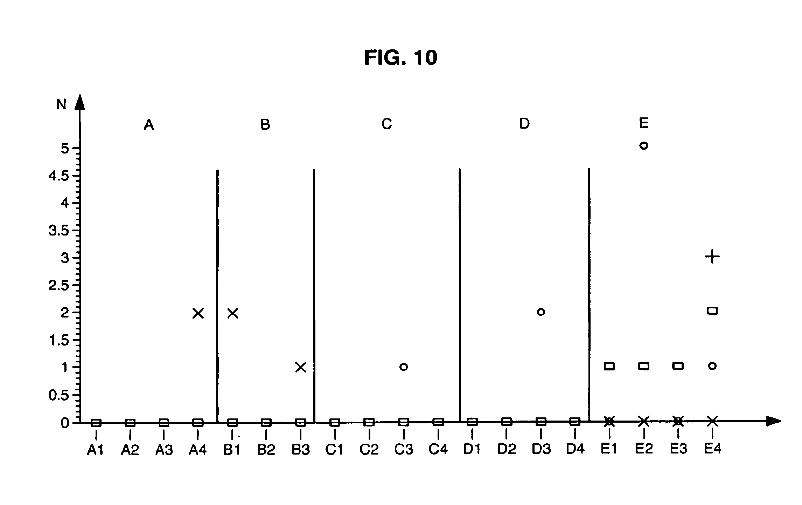

Les résultats observés après le report de couche sont illustrés sur la figure 10.

Celle-ci représente, pour les différents substrats d'un même type d'essai, le nombre de défauts observés par catégorie de défauts.

La légende des figures est la suivante :
+ : µZNT (micro zones non transférées ; taille <0,5 mm)
• : gZNT (grandes zones non transférées ; taille >0,5 mm)
■ : pZNT (petites zones non transférées ; taille 0,5 < taille < 1,5 mm)
x : rayures (à ne pas prendre en compte.

Au vu des résultats obtenus, notamment pour les essais A à C, on peut conclure que quelque soit le traitement plasma appliqué (standard ou doux), et que celui-ci soit appliqué avant ou après la densification, de bons résultats en termes de faible nombre de défauts peuvent être obtenus, à condition que le lissage par plasma soit réalisé avant l'implantation d'espèces atomiques.

Au vu des essais D et E, on constate que lorsque le traitement de lissage est effectué après l'implantation d'espèces atomiques, les résultats obtenus sont nettement moins bons.

Par ailleurs, la comparaison des essais D et E montre que l'activation plasma (AP) du substrat receveur permet de diminuer le nombre de défauts observés après le détachement.

On en déduit que l'activation issue indirectement du lissage effectué avant l'implantation des substrats donneurs de type Si contraint est diminuée, voire éliminée, à cause des différents traitements successifs réalisés après le traitement de lissage plasma.

Les différents essais effectués ont montré les avantages de l'invention.

Le traitement de plasma lissant (SP) a pour effet de diminuer la rugosité de l'isolant épais et le fait qu'il soit suivi d'une implantation de type Smart Cut ® permet d'éliminer l'effet chimique d'activation qu'il a sinon sur l'isolant.

Le procédé conforme à l'invention est également particulièrement bien adapté aux substrats à forte topologie, avec des valeurs de "*pick to valley*" importantes, puisque l'on a montré que la rugosité de tels substrats pouvait également être diminuée par ce procédé.

De plus, dans ce type de substrat, les zones de forte topologie sont généralement situées sur les bords et ce sont à ces endroits que des défauts apparaissent lors du report de couche, si le substrat a été activé. L'enchaînement des étapes du procédé conforme à l'invention qui évite l'activation est donc bien approprié.

## Revendications

1. Procédé de fabrication d'un substrat apte à être utilisé dans les domaines de l'électronique, l'optoélectronique et l'optique, ce procédé comprenant au moins les étapes suivantes, réalisées dans cet ordre :
a) le dépôt, sur un premier substrat (1) dit « donneur », d'une couche d'isolant (2) dont l'épaisseur est supérieure ou égale à 20 nm et dont la rugosité est supérieure ou égale à 3 angströms RMS, pour une largeur de balayage de 2 µm x 2 µm,
b) le traitement de lissage (SP) de la surface libre (20) de cette couche d'isolant (2), en utilisant un plasma gazeux, formé dans une enceinte à l'intérieur de laquelle règne une pression de gaz supérieure à 0,25 Pa, ce plasma étant créé à l'aide d'un générateur de radiofréquences RF, qui fonctionne avec une puissance telle, qu'il permet d'appliquer à ladite couche d'isolant (2), une densité de puissance supérieure à 0,6 W/cm², la durée de ce traitement de lissage étant d'au moins 10 secondes,
c) la formation d'une zone de fragilisation (10) par implantation d'espèces atomiques, à l'intérieur dudit substrat donneur (1), pour y délimiter une couche (11), dite "active" et un reste (12).

2. Procédé selon la revendication 1, **caractérisé en ce qu'**il comprend les étapes suivantes, réalisées après l'étape c) :
d) collage par adhésion moléculaire d'un second substrat (3), dit « receveur », sur ladite surface libre (20) de la couche d'isolant (2),
e) retrait dudit reste (12).

3. Procédé selon la revendication 1 ou 2, **caractérisé en ce qu'**il comprend une étape de recuit de densification de l'isolant (2) déposé à l'étape a), ce recuit étant effectué à une température comprise entre 700 et 1000°C, pendant une durée de plusieurs minutes à plusieurs heures, dans une atmosphère oxydante ou neutre.

4. Procédé selon la revendication 3, **caractérisé en ce que** ledit traitement de recuit de densification est effectué après l'étape b) de lissage par plasma (SP) et avant l'étape c) d'implantation d'espèces atomiques.

5. Procédé selon l'une des revendications précédentes, **caractérisé en ce que** le traitement de lissage par plasma (SP) est effectué avec une densité de puissance comprise entre 0,6 et 10 W/cm², une pression du gaz à l'intérieur de l'enceinte comprise entre 0,25 et 30 Pa et une durée du traitement comprise entre 10 et 200 secondes.

6. Procédé selon la revendication 5, **caractérisé en ce que** la pression du gaz à l'intérieur de l'enceinte est comprise entre 3 et 13 Pa.

7. Procédé selon la revendication 6, **caractérisé en ce que** la pression du gaz est voisine de 7 Pa.

8. Procédé selon l'une des revendications précédentes, **caractérisé en ce que** la durée de l'étape b) de traitement de lissage par plasma (SP) est comprise entre 30 et 120 secondes environ.

9. Procédé selon l'une des revendications précédentes, **caractérisé en ce que** le gaz utilisé pour la formation du plasma de lissage (SP) est choisi parmi l'oxygène (O₂), l'argon (Ar), l'azote (N₂) ou un mélange de ces gaz.

10. Procédé selon l'une des revendications précédentes, **caractérisé en ce que** le gaz utilisé pour la formation du plasma de lissage (SP) est choisi de façon que la nature des atomes le constituant soit la même qu'au moins l'un des atomes constituant ladite couche d'isolant (2) à traiter.

11. Procédé selon l'une des revendications 2 à 10, **caractérisé en ce que** entre les étapes c) et d), on procède à un traitement d'activation plasma (AP) de ladite couche d'isolant (2), en utilisant un plasma gazeux, formé dans une enceinte à l'intérieur de laquelle règne une pression de gaz d'environ 7 Pa, ce plasma étant créé à l'aide d'un générateur de radiofréquences RF, qui fonctionne avec une puissance telle, qu'il permet d'appliquer à ladite couche d'isolant (2), une densité de puissance supérieure à 0,2 W/cm², la durée de ce traitement d'activation plasma étant d'au moins 5 secondes.

12. Procédé selon la revendication 11, **caractérisé en ce que** le traitement d'activation plasma (AP) est effectué avec une densité de puissance comprise entre 0,2 et 3W/cm², et une durée de traitement comprise entre 5 et 60 secondes.

13. Procédé selon l'une des revendications précédentes, **caractérisé en ce que** l'épaisseur de la couche d'isolant (2) est supérieure ou égale à 200 nm.

14. Procédé selon l'une des revendications précédentes, **caractérisé en ce que** l'isolant (2) est obtenu par une technique de dépôt chimique en phase vapeur sous faible pression LPCVD.

15. Procédé selon l'une des revendications précédentes, **caractérisé en ce que** l'isolant (2) est un oxyde.

16. Procédé selon la revendication 15, **caractérisé en ce que** l'oxyde est un dioxyde de silicium (SiO₂), obtenu par une technique de dépôt chimique en phase vapeur sous faible pression, à partir de tétraéthylorthosilicate (LPCVD TEOS).

17. Procédé selon la revendication 16, **caractérisé en ce que** le dioxyde de silicium (SiO₂) est déposé à une pression comprise entre 40 et 200 Pa.

18. Procédé selon l'une des revendications 1 à 14, **caractérisé en ce que** l'isolant (2) est un nitrure ou un oxynitrure.

19. Procédé selon l'une des revendications précédentes, **caractérisé en ce que** ladite couche active (11) comprend du silicium.

20. Procédé selon l'une des revendications précédentes, **caractérisé en ce que** ladite couche active (11) comprend du silicium contraint.

## Claims

1. Method for manufacturing a substrate intended for use in the electronics, optoelectronics and optics fields, this method comprising at least the following steps, performed in this order:
a) deposit an insulator layer (2) with a thickness greater than or equal to 20 nm, with a roughness greater than or equal to 3 Angstroms RMS, for a scan width of 2 µm x 2 µm on a first so-called "donor" substrate (1),
b) the smoothing treatment (SP) of the free surface (20) of this insulator layer (2) using a gas plasma formed in a chamber inside which the gas pressure is more than 0.25 Pa, this plasma being created using a radiofrequency RF generator operating under a power such that it can apply a power density greater than 0.6 W/cm² to said insulator layer (2), the duration of this smoothing treatment being at least 10 seconds.
c) formation of an embrittlement zone (10) by implantation of atomic species inside said donor substrate (1), to delimit a so-called "active" layer (11) and a remainder (12).

2. Method according to claim 1, **characterised in that** it comprises the following steps, carried out after step c):
d) molecular bonding of a second substrate (3) called the "receiver" on said free surface (20) of the insulator layer (2),
e) withdrawal of said remainder (12).

3. Method according to claim 1 or 2, **characterised in that** it comprises a densification annealing step for the insulation (2) deposited in step a), this annealing being done at a temperature of between 700 and 1000°C for a duration of several minutes to several hours in an oxidising or neutral atmosphere.

4. Method according to claim 3, **characterised in that** said densification annealing treatment is done after the smoothing plasma (SP) step b) and before the atomic species implantation step c).

5. Method according to one of previous claims, **characterised in that** the smoothing plasma (SP) treatment is done with a power density of between 0.6 and 10 W/cm², a gas pressure inside the chamber of between 0.25 and 30 Pa and a treatment duration of between 10 and 200 seconds.

6. Method according to claim 5, **characterised in that** the gas pressure inside the chamber is between 3 and 13 Pa.

7. Method according to claim 6, **characterised in that** the gas pressure is approximately 7 Pa.

8. Method according to one of previous claims, **characterised in that** the duration of the smoothing plasma (SP) treatment step b) is between about 30 and 120 seconds.

9. Method according to one of previous claims, **characterised in that** the gas used for formation of the smoothing plasma (SP) is chosen from among oxygen (O₂), argon (Ar), nitrogen (N₂) or a mixture of these gases.

10. Method according to one of previous claims, **characterised in that** the gas used for formation of the smoothing plasma (SP) is chosen such that the nature of the atoms from which it is made is the same as at least one of the atoms forming said insulator layer (2) to be treated.

11. Method according to one of claims 2 to 10, **characterised in that** between steps c) and d), a activation plasma (AP) treatment of said insulator layer (2) is performed using a gas plasma formed in a chamber inside which there is a gas pressure of about 7 Pa, this plasma being created using a radiofrequency RF generator that operates at a power such that it can apply a power density exceeding 0.2 W/cm² to said insulator layer (2), the duration of this activation plasma treatment being at least 5 seconds.

12. Method according to claim 11, **characterised in that** the activation plasma (AP) treatment is carried out with a power density of between 0.2 and 3 W/cm², and a treatment duration of between 5 and 60 seconds.

13. Method according to one of previous claims, **characterised in that** the thickness of the insulator layer (2) is greater than or equal to 200 nm.

14. Method according to one of previous claims, **characterised in that** the insulation (2) is obtained by a low pressure vapour phase chemical deposition LPCVD technique.

15. Method according to one of previous claims, **characterised in that** the insulation (2) is an oxide.

16. Method according to claim 15, **characterised in that** the oxide is a silicon dioxide (SiO₂) obtained by a low pressure chemical vapour phase deposition technique starting from tetraethylorthosilicate (TEOS LPCVD).

17. Method according to claim 16, **characterised in that** the silicon dioxide (SiO₂) is deposited at a pressure of between 40 and 200 Pa.

18. Method according to one of claims 1 to 14, **characterised in that** the insulation (2) is a nitride or an oxinitride.

19. Method according to one of previous claims, **characterised in that** said active layer (11) comprises silicon.

20. Method according to one of previous claims, **characterised in that** said active layer (11) comprises strained silicon.

## Patentansprüche

1. Verfahren zur Herstellung eines Substrats, das für die Verwendung in den Bereichen Elektronik, Optoelektronik und Optik geeignet ist, wobei dieses Verfahren zumindest die folgenden Schritte umfasst, die in dieser Reihenfolge durchgeführt werden:
a) Abscheidung auf einem ersten Substrat (1), dem sog. "Geber"-Substrat, einer Isolierschicht (2), deren Dicke größer oder gleich 20 nm ist und deren Rauheit größer oder gleich 3 Angström RMS ist, bei einer Abtastbreite von 2 µm x 2 µm,
b) Behandlung durch Glättung (SP) der freien Oberfläche (20) dieser Isolierschicht (2), indem ein gasförmiges Plasma verwendet wird, das in einem Raum gebildet wird, in dessen Innern ein Gasdruck herrscht, der größer als 0,25 Pa ist, wobei dieses Plasma mit Hilfe eines Radiofrequenz- (RF)-Generators erzeugt wird, der mit einer Leistung arbeitet, die es ermöglicht, auf die Isolierschicht (2) eine Leistungsdichte aufzubringen, die größer als 0,6 W/cm² ist, wobei die Dauer dieser Behandlung durch Glättung zumindest 10 Sekunden beträgt,
c) Bildung einer Versprödungszone (10) durch die Einbringung von atomaren Spezies im Innern des Gebersubstrats (1), um dort eine sog. "aktive" Schicht (11) und einen Rest (12) zu begrenzen.

2. Verfahren nach Anspruch 1, **dadurch gekennzeichnet, dass** es die folgenden Schritte umfasst, die nach Schritt c) ausgeführt werden:
d) Aufkleben eines zweiten Substrats (3), des sog. "Nehmer"-Substrats, auf der freien Oberfläche (20) der Isolierschicht (2) durch Molekularhaftung,
e) Entfernen des Restes (12).

3. Verfahren nach Anspruch 1 oder 2, **dadurch gekennzeichnet, dass** es einen Schritt zur Verdichtungshärtung des Isoliermaterials (2), das in Schritt a) abgeschieden wird, aufweist, wobei diese Härtung bei einer Temperatur zwischen 700 und 1000 °C über eine Dauer von mehreren Minuten bis zu mehreren Stunden in einer oxidierenden oder neutralen Atmosphäre durchgeführt wird.

4. Verfahren nach Anspruch 3, **dadurch gekennzeichnet, dass** diese Behandlung durch Verdichtungshärtung nach dem Schritt b) zur Plasmaglättung (SP) und vor dem Schritt c) zur Einbringung von atomaren Spezies durchgeführt wird.

5. Verfahren nach einem der vorhergehenden Ansprüche, **dadurch gekennzeichnet, dass** die Behandlung durch Plasmaglättung (SP) mit einer Leistungsdichte zwischen 0,6 und 10 W/cm², einem Gasdruck im Innern des Raumes zwischen 0,25 und 30 Pa und einer Behandlungsdauer zwischen 10 und 200 Sekunden durchgeführt wird.

6. Verfahren nach Anspruch 5, **dadurch gekennzeichnet, dass** der Gasdruck im Innern des Raumes zwischen 3 und 13 Pa beträgt.

7. Verfahren nach Anspruch 6, **dadurch gekennzeichnet, dass** der Gasdruck in etwa 7 Pa beträgt.

8. Verfahren nach einem der vorhergehenden Ansprüche, **dadurch gekennzeichnet, dass** die Dauer von Schritt b) zur Behandlung durch Plasmaglättung (SP) zwischen ungefähr 30 und 120 Sekunden beträgt.

9. Verfahren nach einem der vorhergehenden Ansprüche, **dadurch gekennzeichnet, dass** das zur Bildung des Glättungsplasma (SP) verwendete Gas ausgewählt ist aus Sauerstoff (O₂), Argon (Ar), Stickstoff (N₂) oder einem Gemisch aus diesen Gasen.

10. Verfahren nach einem der vorhergehenden Ansprüche, **dadurch gekennzeichnet, dass** das zur Bildung des Glättungsplasma (SP) verwendete Gas so gewählt ist, dass die Beschaffenheit der Atome, aus denen es besteht, die gleiche ist wie von zumindest einem der Atome, aus denen die zu behandelnde Isolierschicht (2) besteht.

11. Verfahren nach einem der Ansprüche 2 bis 10, **dadurch gekennzeichnet, dass** zwischen Schritt c) und Schritt d) eine Behandlung der Isolierschicht (2) durch Plasma-Aktivierung (AP) vorgenommen wird, indem ein gasförmiges Plasma verwendet wird, das in einem Raum gebildet wird, in dessen Innern ein Gasdruck von ungefähr 7 Pa, wobei dieses Plasma mit Hilfe eines Radiofrequenz-(RF)-Generators erzeugt wird, der mit einer Leistung arbeitet, die es ermöglicht, auf die Isolierschicht (2) eine Leistungsdichte aufzubringen, die größer als 0,2 W/cm² ist, wobei die Dauer dieser Behandlung durch Plasma-Aktivierung zumindest 5 Sekunden beträgt.

12. Verfahren nach Anspruch 11, **dadurch gekennzeichnet, dass** die Behandlung durch Plasma-Aktivierung (AP) mit einer Leistungsdichte zwischen 0,2 und 3 W/cm² und einer Behandlungsdauer zwischen 5 und 60 Sekunden durchgeführt wird.

13. Verfahren nach einem der vorhergehenden Ansprüche, **dadurch gekennzeichnet, dass** die Dicke der Isolierschicht (2) größer oder gleich 200 nm ist.

14. Verfahren nach einem der vorhergehenden Ansprüche, **dadurch gekennzeichnet, dass** das Isoliermaterial (2) durch eine Technik der chemischen Niederdruck-Gasphasenabscheidung (LPCVD) erhalten wird.

15. Verfahren nach einem der vorhergehenden Ansprüche, **dadurch gekennzeichnet, dass** das Isoliermaterial (2) ein Oxid ist.

16. Verfahren nach Anspruch 15, **dadurch gekennzeichnet, dass** das Oxid ein Siliziumdioxid (SiO₂) ist, das durch eine Technik der chemischen Niederdruck-Gasphasenabscheidung ausgehend von Tetraethylorthosilicat (LPCVD TEOS) erhalten wird.

17. Verfahren nach Anspruch 16, **dadurch gekennzeichnet, dass** das Siliziumdioxid (SiO₂) bei einem Druck zwischen 40 und 200 Pa abgeschieden wird.

18. Verfahren nach einem der Ansprüche 1 bis 14, **dadurch gekennzeichnet, dass** das Isoliermaterial (2) ein Nitrid oder ein Oxynitrid ist.

19. Verfahren nach einem der vorhergehenden Ansprüche, **dadurch gekennzeichnet, dass** die aktive Schicht (11) Silizium umfasst.

20. Verfahren nach einem der vorhergehenden Ansprüche, **dadurch gekennzeichnet, dass** die aktive Schicht (11) gespanntes Silizium umfasst.
